Europäisches Patentamt

European Patent Office

Office européen des brevets

(19)

(11) Publication number: **0 297 144**

**A1**

## EUROPEAN PATENT APPLICATION

published in accordance with Art. 158(3) EPC

(21) Application number: **88900119.4**

(22) Date of filing: **18.12.87**

Data of the international application taken as a basis:

(86) International application number:
**PCT/JP87/00997**

(87) International publication number:
**WO88/04880 (30.06.88 88/14)**

(51) Int. Cl.³: **H 05 K 7/20**
**H 05 K 7/06**

(30) Priority: **20.12.86 JP 304629/86**

(43) Date of publication of application:
**04.01.89 Bulletin 89/1**

(84) Designated Contracting States:
**DE FR GB IT**

(71) Applicant: **FANUC LTD**
**3580, Shibokusa Aza-Komanba Oshino-mura**
**Minamitsuru-gun Yamanashi 401-05(JP)**

(72) Inventor: **KOBARI, Katsuo**
**Fujimi-cho Danchi 35-210 17, Fujimi-cho 6-chome**
**Tachikawa-shi Tokyo 190(JP)**

(74) Representative: **Billington, Lawrence Emlyn et al,**
**HASELTINE LAKE & CO Hazlitt House 28 Southampton**
**Buildings Chancery Lane**
**London WC2A 1AT(GB)**

(54) **CONTROL UNIT.**

(57) A metallic surface board equipped with a plastic frame is fitted to a hole formed in the center. On the front surface of the plastic frame are mounted electric components such that the electric components and the radiator fins are located on the front side. Terminals of the electric components penetrate through the plastic frame and are located on the back side. A barrier is provided on the front surface of the plastic frame to surround the base portions of the electric components, and another barrier is provided on the back surface of the plastic frame to surround the terminals of the electric components. The back surface of the surface board is covered with a covering.

Fig. 2

2 FRONT PLATE
2a
1 PLASTIC FRAME
3 SEMICONDUCTOR CONTROL ELEMENT
3a
3b
1c
1c
4 CONTROL RESISTOR
4a
1a BARRIER
5 COVER
1b
2b HOLE
5a
FRAME POSITION

Croydon Printing Company Ltd.

EP 0 297 144 A1

-1-

DESCRIPTION

CONTROL UNIT

Technical Field

This invention relates to a control unit for accommodating power control members which drive a servomotor or the like.

Background Art

A control unit accommodating such electrical components as semiconductor control elements, a transformer, capacitors and resistors for control of electrical power is used as the control device of servomotors employed in machine tools and the like.

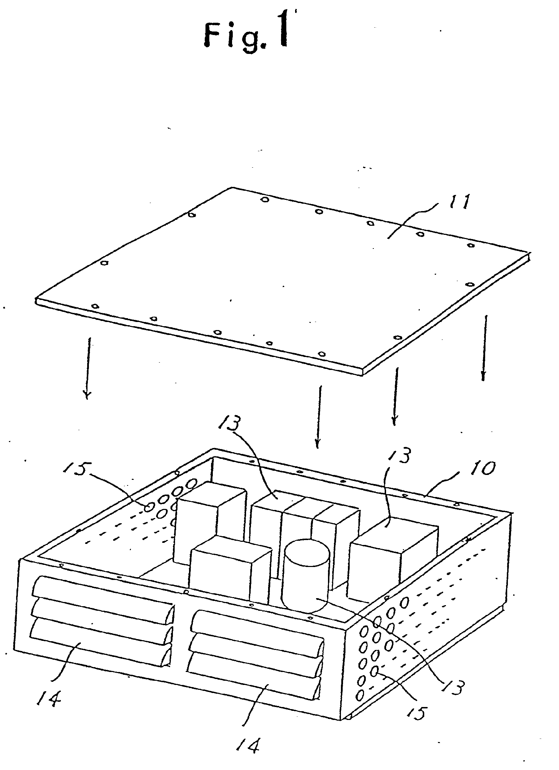

Fig. 1 is a perspective view of a control unit of this type. Here a sheet-metal case 10 consisting of shaped iron plates or aluminum is covered by a cover portion 11 and internally accommodates wired electrical components 13.

In a control unit accommodated within such a sheet-metal case, radiators for large-size semiconductor elements and heat-emitting members such as power resistors are also enclosed. Accordingly, ventilating louvers 14 and perforated metal 15 are used in the sheet-metal case 10 for the purpose of radiating heat. Consequently, labor is required to work the sheet-metal case.

Though the ability to radiate heat from the interior of the unit is improved by ventilating the sheet-metal case, ventilation allows dust to penetrate the interior of the sheet-metal case with extended use, and build-up of such dust on electrified portions, for example, may lead to unexpected problems that can cause insulation breakdown and the like.

The present invention has been devised in view of the foregoing problems and its object is to provide a control unit in which the ventilation and dust-proof properties are improved by using an inexpensive plastic case to mount the control members.

## Disclosure of the Invention

In accordance with the present invention, there is provided a control unit accommodating electrical components, which include power components having heat radiating fins, for controlling power apparatus, comprising a plastic frame having a flange on which the electrical components are mounted, and electrical components having terminal portions which project from a surface of the flange, the terminal portions of the electrical components being projectingly attached to an accommodating inner surface of the plastic frame.

According to the invention, costs are not high since the plastic frame is used to mount the electrical components. Also, a dust-proof effect is obtained since the terminal portions are directed toward the accommodating inner surface and, hence, do not come into direct contact with the outside air. In addition, an excellent heat radiating effect is obtained since the heat radiating fins of the power components are exposed to the outside air.

Since a frame portion covering the mounted portions of the electrical components is provided on the plastic frame, there is no risk of a build-up of dust or the like even after long use in the open air.

Brief Description of the Drawings

Fig. 1 is a perspective view of a conventional control unit using a sheet-metal case;

Fig. 2 is a side view illustrating an embodiment of a control unit according to the present invention; and

Fig. 3 is a partial perspective view illustrating a portion of a plastic frame.

Best Mode for Carrying Out the Invention

An embodiment of the present invention will now be described in detail with reference to the drawings.

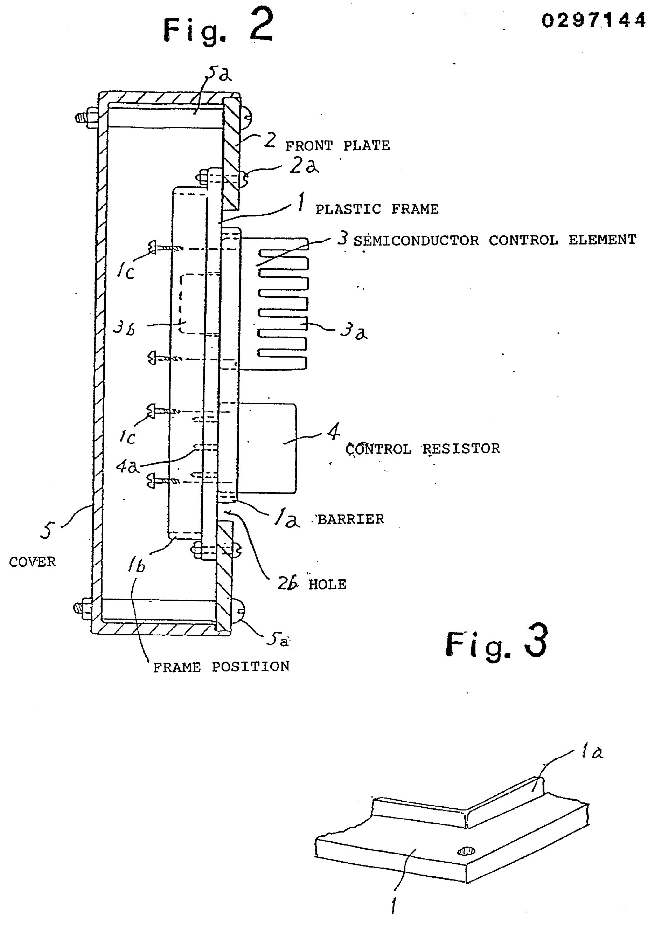

Fig. 2 is a side view illustrating an embodiment of a control unit according to the present invention. In Fig. 2, numeral 1 denotes a plastic frame comprising a synthetic resin and attached by locking screws 2a to a front plate 2 consisting of a metal plate so as to close, from the reverse side, a rectangular hole 2b provided in the center of the front plate 2. Integrally molded on the outer surface of the plastic frame 1 is a barrier 1a surrounding the periphery of the base portions of electrical components attached to the plastic frame 1, these base portions being in contact with the plastic frame 1. The barrier serves to prevent the adhesion of dust to the flange portion and assists in positioning at the time the parts are assembled. A barrier 1b surrounding the terminal portions of the electrical components is provided on the inner surface of the plastic frame 1. Numeral 3 denotes a semiconductor control element having a heat radiating fin 3a, and numeral 4 denotes a power resistor. The semiconductor control element 3 and the power resistor 4 have respective terminals portions 3b, 4a projecting from the flange surface, and they are attached by mounting screws 1c in such a manner that the terminal portions project toward the inner surface side upon being passed through prescribed through-holes provided in the plastic frame 1. Other electrical components (not shown) for power apparatus control are attached to the plastic frame 1 by a mounting method corresponding to that used for the semiconductor control element 3 and power resistor 4. For example, the electrical components are arranged with their main body portions, each of which has a metal cover, and heat radiating fins situated on the outer side, and with their terminal portions situated on the inner surface side, and these components are connected along with the semiconductor control element 3 and power resistor 4 to construct a prescribed control circuit. Numeral 5 denotes a cover attached to the front plate 2 by mounting screws 5a for covering the inner surface of the frame 1 to protect the connections of the electrical component terminal portions.

In the control unit of the present invention as described above, the electrical components inclusive of heat radiating fins are attached to the plastic frame 1 by the flange in such a manner that their terminal portions are directed toward the inner surface of the unit, and the adhesion of dust or the like at the mounting portion is prevented by the barrier 1a provided on the plastic frame 1. The heat radiating fins and the metal covers of the electrical components are in direct contact with the outside air.

In the present embodiment, the barrier 1a is illustrated in the drawings as a frame surrounding the mounting portions of all of a number of electrical components. However, the barrier may be provided as a frame surrounding the flange portions of individual electrical components.

Though the present invention has been described in conjunction with an embodiment thereof, the invention can be modified in various ways without departing from the scope of the claims.

Industrial Applicability

In accordance with the present invention, electrical components serving as control devices, such as power electrical components for controlling power apparatus, are attached at a flange by using a plastic frame, without relying upon a sheet-metal case, in such a manner that the radiating fins and metal covers of these components are situated on the outer side while the terminal portions and connections are situated on the inner surface side. As a result, costs are reduced in comparison with sheet metal work. Since the heat radiating fins and the like are directly exposed to the outside air, an excellent heat radiating effect is obtained.

Further, in accordance with the present invention, a barrier for covering the mounting portions of the electrical components is provided on the plastic frame. This prevents unforeseen problems by preventing the adhesion of dust.

CLAIMS:

1. A control unit accommodating electrical components, which include power components having heat radiating fins, for controlling power apparatus, comprising:

electrical components each having terminal portions provided on a bottom surface of a main body portion which includes heat radiating fins; and

a plastic frame comprising a plate-shaped body of synthetic resin and having holes through which the terminal portions of the electrical components are inserted, said electrical components being mounted on a surface portion by passing the terminals of the electrical components through said holes.

2. A control unit according to claim 1, characterized in that a front side of said plastic frame is provided with a barrier surrounding base portions of said electrical components.

3. A control unit according to claim 1, characterized in that a reverse side of said plastic frame is provided with a barrier surrounding the terminal portions of said electrical components.

4. A control unit according to claim 1, characterized in that a front side of said plastic frame is provided with a barrier surrounding base portions of said electrical components, and a reverse side of said plastic frame is provided with a barrier surrounding the terminal portions of said electrical components.

5. A control unit according to claim 1, characterized in that the plastic frame to which said electrical components are mounted is attached to holes in a front plate comprising a plate-shaped body made of metal, a cover being provided on a reverse side thereof.

# Fig.1

# Fig. 2

0297144

- 5a
- 2 FRONT PLATE
- 2a
- 1 PLASTIC FRAME
- 3 SEMICONDUCTOR CONTROL ELEMENT
- 1c
- 3b
- 3a
- 1c
- 4 CONTROL RESISTOR
- 4a
- 1a BARRIER
- 5
- COVER
- 1b
- 2b HOLE
- 5a
- FRAME POSITION

# Fig. 3

- 1a
- 1

# INTERNATIONAL SEARCH REPORT

International Application No | PCT/JP87/00997

**I. CLASSIFICATION OF SUBJECT MATTER** (if several classification symbols apply, indicate all) *

According to International Patent Classification (IPC) or to both National Classification and IPC

Int.Cl⁴    H05K7/20, 7/06

**II. FIELDS SEARCHED**

Minimum Documentation Searched ⁴

| Classification System | Classification Symbols |
|---|---|
| IPC | H05K7/20, 7/06, 5/02 |

Documentation Searched other than Minimum Documentation
to the Extent that such Documents are Included in the Fields Searched ⁵

| | |
|---|---|
| Jitsuyo Shinan Koho | 1926 - 1987 |
| Kokai Jitsuyo Shinan Koho | 1971 - 1987 |

**III. DOCUMENTS CONSIDERED TO BE RELEVANT** ¹⁴

| Category * | Citation of Document, ¹⁶ with indication, where appropriate, of the relevant passages ¹⁷ | Relevant to Claim No. ¹⁸ |
|---|---|---|
| Y | JP, A, 59-165499 (Sony Corporation) 18 September 1984 (18. 09. 84) Column 8, lines 3 to 10 (Family: none) | 1, 2, 4 |
| Y | JP, A, 56-116698 (Hitachi, Ltd.) 12 September 1981 (12. 09. 81) Column 3, lines 13 to 18 (Family: none) | 1 |
| Y | JP, U, 57-175494 (Oki Electric Industry Co., Ltd.) 5 November 1982 (05. 11. 82) Column 1, lines 2 to 6 (Family: none) | 1, 3, 5 |
| Y | JP, U, 58-155889 (Hitachi, Ltd.) 18 October 1983 (18. 10. 83) Column 1, lines 2 to 3 (Family: none) | 3 |

* Special categories of cited documents: ¹⁶
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance the claimed invention cannot be considered novel or cannot be considered to involve an inventive step
"Y" document of particular relevance. the claimed invention cannot be considered to involve an inventive step when the document is combined with one or more other such documents. such combination being obvious to a person skilled in the art
"&" document member of the same patent family

**IV. CERTIFICATION**

| Date of the Actual Completion of the International Search ² | Date of Mailing of this International Search Report ² |
|---|---|
| February 29, 1988 (29.02.88) | March 14, 1988 (14.03.88) |
| International Searching Authority ¹ | Signature of Authorized Officer ²⁰ |
| Japanese Patent Office | |

Form PCT/ISA/210 (second sheet) (October 1977)